# EUROPÄISCHE PATENTSCHRIFT

(11) **EP 4 198 482 B1**
(45) Veröffentlichungstag und Bekanntmachung des Hinweises auf die Patenterteilung: **11.06.2025**
(21) Anmeldenummer: 21215409.0
(22) Anmeldetag: 17.12.2021
(51) Int. Cl.: G01M 17/06, G06F 30/15, G06T 13/20

(54) **ERSTELLEN VON TESTDATEN MIT KONSISTENTEN ANFANGSBEDINGUNGEN ZUM STIMULIEREN EINES ZU TESTENDEN STEUERGERÄTS**
GENERATION OF TEST DATA WITH CONSISTENT INITIAL CONDITIONS FOR STIMULATING A CONTROLLER TO BE TESTED
CRÉATION DE DONNÉES D'ESSAI AYANT DES CONDITIONS DE DÉPART COHÉRENTES PERMETTANT DE STIMULER UN APPAREIL DE COMMANDE À METTRE À L'ESSAI

(43) Veröffentlichungstag der Anmeldung: 21.06.2023
(73) Patentinhaber: dSPACE GmbH, 33102 Paderborn (DE)
(72) Erfinder: Schütte, Dr, Frank, 33102 Paderborn (DE); Haupt, Hagen, 33102 Paderborn (DE)

(56) Entgegenhaltungen:
- WO-A1-2020/264276
- DE-A1- 102019 124 504
- US-A1- 2019 354 643
- US-A1- 2020 184 027
- US-A1- 2020 339 109
- US-A1- 2021 166 474
- US-B1- 10 482 003
- US-B1- 11 150 660

## Beschreibung

Die Erfindung betrifft ein Verfahren zum Verarbeiten von mittels eines Sensors aufgezeichneten Rohdaten aus der realen Welt zu Testdaten zum Stimulieren eines zu testenden Steuergeräts, mit folgenden Verfahrensschritten:
Bereitstellen von aufgezeichneten Rohdaten aus der realen Welt, die mittels eines Sensors für eine Aufzeichnungsdauer längs einer Aufzeichnungsstrecke von wenigstens einem Teil der Umgebung der Aufzeichnungsstrecke aufgezeichnet worden sind und dabei zeitlich aufeinanderfolgende Datenwertsätze aufweisen, die sich aufgrund von von dem Sensor erfassten realen Objekten ergeben haben, und
Ermitteln der von dem Sensor erfassten realen Objekte aus den zeitlich aufeinanderfolgenden Datenwertsätzen und Erstellen von zeitlich aufeinanderfolgenden Streckendatensätzen, die jeweils eine Szene mit Bildern dieser realen Objekte zu aufeinanderfolgenden Zeitpunkten beschreiben.

In den Bereichen "Advanced Driver Assistance Systems" (ADAS) und "Autonomous Driving" (AD) ist die Validierung von Sensor-, Sensorfusions- und Perzeptionskomponenten ein wichtiges und sicherheitskritisches Unterfangen. Aufgrund der Komplexität und Kritikalität dieser Validierung werden sehr hohe Anforderungen an deren Sicherheit und Genauigkeit gestellt. Um dies zu bewältigen, werden häufig aufgezeichnete Daten aus der realen Welt verwendet, also Daten, die beim Fahren mit einem realen Kraftfahrzeug in der realen Welt mit Hilfe von an dem Kraftfahrzeug angebrachten Sensoren erfasst worden sind. Auf solche Weise aufgezeichnete Daten zeichnen sich durch eine Realitätsnähe und -treue aus, die mit synthetischen Simulationsdaten im Stand der Technik nicht erreichbar ist. Die Validierung und der Test von ADAS/AD-Perzeptions- und Sensorfusionskomponenten durch die Wiedergabe aufgezeichneter Daten, auch Datenwiederverarbeitung, Datenresimulation, Datenwiedergabe und Data Replay genannt, ist somit ein wichtiger Aspekt bei der Entwicklung von ADAS/AD-Systemen.

Hohe Präzision und Realismus zu erreichen, ist aufwändig und anspruchsvoll. Das zu testende System muss mit den aufgezeichneten Daten im Prinzip genauso gespeist werden, wie es bei einer realen Testfahrt der Fall wäre. Heterogene Datenströme, einschließlich Sensor- und Netzwerk-/Busdaten, müssen während des Datenwiedergabeprozesses synchronisiert werden, auch wenn sich ihre Paket-/Meldungsgröße unterscheiden kann. Darüber hinaus nimmt die schiere Menge der gestreamten Daten stetig zu. Eine weitere Herausforderung ist die komplexe Echtzeitanpassung der aufgezeichneten Daten, um die End-to-End-Verschlüsselung und die Sicherheitsprüfungen im zu testenden System (SUT) zu bestehen. Darüber hinaus ist die effiziente Skalierung des Tests zur kontinuierlichen Versorgung von Millionen gefahrener Kilometer und zur Orchestrierung mehrerer Testsysteme von entscheidender Bedeutung.

Aus dem Stand der Technik sind unterschiedliche Lösungen für verschiedene Anwendungsfälle der Datenwiedergabe bekannt, unabhängig davon, ob das SUT physisch verfügbar ist (Hardware in the loop - HIL) oder sich noch in der frühen Software-Entwicklungsphase befindet (Software in the loop - SIL) und ob es sich um eine einfache Sensorkomponente oder eine komplexe zentrale Berechnungsplattform für autonomes Fahren handelt.

Die WO2020/264276 A1 befasst sich mit einem Verfahren zum Generieren von virtuelle Szenarien zum Testen von Fahrzeugen anhand von Daten die von einem realen Fahrzeug erfasst worden sind, wobei Daten von realen Objekten benutzt werden, um simulierte Objekte zu generieren, dessen Position und Größe sich in der Zeit ändern können.

Herkömmliche Simulationssysteme ermöglichen es, Steuergeräte mit synthetischen Sensorrohdaten zu stimulieren. Wenn der Initialzustand des Szenarios, auf dessen Basis die Rohdaten erzeugt werden, allerdings nicht plausibel ist, kann es vorkommen, dass das sich im Test befindliche Steuergerät oder eine dem Steuergerät nachgeschaltete Komponente die Situation nicht verarbeiten kann und der Test daher scheitert. Das kann insbesondere der Fall sein, wenn die Simulation bei voller Fahrt des virtuellen Testfahrzeugs beginnt oder Objekte in der durchfahrenen Umgebung in unnatürlicher Weise plötzlich auftauchen, verschwinden oder von einem Ort zum anderen springen.

Davon ausgehend ist es die Aufgabe der Erfindung, ein Verfahren zum Erzeugen derartiger Testdaten für ein zu testendes Steuergerät anzugeben, die keine Unplausibilitäten aufweisen, aufgrund derer es zu einem Abbruch eines Tests des zu testenden Steuergeräts kommen würde.

Diese Aufgabe wird durch die Gegenstände der unabhängigen Patentansprüche gelöst. Bevorzugte Weiterbildungen finden sich in den Unteransprüchen.

Erfindungsgemäß wird somit ein Verfahren zum Verarbeiten von mittels eines Sensors aufgezeichneten Rohdaten aus der realen Welt zu Testdaten zum Stimulieren eines zu testenden Steuergeräts bereitgestellt, das die folgenden Verfahrensschritte aufweist:
Bereitstellen von aufgezeichneten Rohdaten aus der realen Welt, die mittels eines Sensors für eine Aufzeichnungsdauer längs einer Aufzeichnungsstrecke von wenigstens einem Teil der Umgebung der Aufzeichnungsstrecke aufgezeichnet worden sind und dabei zeitlich aufeinanderfolgende Datenwertsätze aufweisen, die sich aufgrund von von dem Sensor erfassten realen Objekten ergeben haben,
Ermitteln von von dem Sensor erfassten realen Objekten aus den zeitlich aufeinanderfolgenden Datenwertsätzen und Erstellen von zeitlich aufeinanderfolgenden Streckendatensätzen, die jeweils eine Szene mit Bildern dieser realen Objekte zu aufeinanderfolgenden Zeitpunkten beschreiben,
Bereitstellen einer Bibliothek mit synthetischen Objekten,
Ermitteln der Absolutgeschwindigkeit des Sensors längs der Aufzeichnungsstrecke zum Zeitpunkt Null der Aufzeichnungsdauer und für den Fall, dass die Absolutgeschwindigkeit des Sensors längs der Aufzeichnungsstrecke zum Zeitpunkt Null der Aufzeichnungsdauer von Null verschieden ist, Ergänzen der zeitlich aufeinanderfolgenden Streckendatensätze für eine Einleitungsdauer vor dem ersten Streckendatensatz mit zeitlich aufeinanderfolgenden Ergänzungsdatensätzen, derart, dass der Sensor zum Zeitpunkt Null der Einleitungsdauer eine Absolutgeschwindigkeit von Null aufweist und die zeitlich aufeinanderfolgenden Ergänzungsdatensätze synthetische Objekte aufweisen, die zwischen zeitlich unmittelbar aufeinanderfolgenden Ergänzungsdatensätzen eine quasistetige zeitliche Bewegungsabfolge zeigen, die quasistetig zu den Bildern der realen Objekte des ersten Streckendatensatzes zum Zeitpunkt Null der Aufzeichnungsdauer führen, und
Erzeugen der Testdaten zum Stimulieren eines zu testenden Steuergeräts durch Konvertieren der Ergänzungsdatensätze zu solchen Rohdaten, wie sie mittels des Sensors während der Einleitungsdauer in der realen Welt aufgezeichnet worden wären, wenn der Sensor die synthetischen Objekte in den zeitlich aufeinanderfolgenden Ergänzungsdatensätzen als reale Objekte erfasst hätte, und Ergänzen der aufgezeichneten Rohdaten vor dem ersten Streckendatensatz zum Zeitpunkt Null der Aufzeichnungsdauer mit den durch Konvertieren der Ergänzungsdatensätze erhaltenen Rohdaten.

Zur Lösung der oben genannten Aufgabe schlägt die Erfindung also vor, automatisiert ein "Einführungsszenario" zu erstellen, das aus einem plausiblen Anfangszustand startet und nahtlos in den Initialzustand eines ursprünglichen Szenarios überführt, das sich auf der Grundlage der mittels des Sensors aufgezeichneten Rohdaten aus der realen Welt ergeben hat. Die Erfindung ist besonders für Data Replay nützlich, wenn die Aufnahme der Rohdaten mitten in der Fahrt beginnt oder nur ein Ausschnitt einer Aufnahme genutzt werden soll. Erfindungsgemäß werden die aufgenommenen Rohdaten um ein Einführungsszenario mit virtuellen Szenarien erweitert, so dass das Ergebnis dann wieder in ein Quasi-Rohdatenformat mit einem plausiblen Initialzustand konvertiert werden kann.

Wenn sich beim Aufzeichnen der Rohdaten der Sensor längs der Aufzeichnungsstrecke durch seine Umgebung bewegt, ist die Relativbewegung der von dem Sensor erfassten Objekte zum Sensor in der realen Welt immer im mathematischen Sinn stetig. Das gilt unabhängig davon, ob sich die erfassten Objekte selbst in der Umgebung bewegen oder nicht. Da eine Aufzeichnung der Daten aus der realen Welt vorliegend freilich diskret erfolgt, nämlich mit zeitlich aufeinanderfolgenden Datenwertsätzen, gibt es von Datenwertsatz zu Datenwertsatz bei einer von Null verschiedenen Relativgeschwindigkeit zwischen dem Sensor und einem erfassten realen Objekt immer Unstetigkeiten im mathematischen Sinne. Daher wird im Rahmen der vorliegenden Erfindung der Begriff "quasistetig" verwendet, um zu beschreiben, dass, wie in der realen Welt auch, die Objekte nämlich nicht plötzlich auftauchen und auch nicht plötzlich wieder verschwinden. Außerdem springen die Objekte auch nicht von einem Ort zum anderen. Vielmehr strebt die Erfindung bei der Erstellung der Ergänzungsdatensätze, wie in der realen Welt auch, eine Bewegung der Objekte relativ zum Sensor an, die in dem Sinne "quasistetig" ist, als dass vom menschlichen Betrachter bei einer bildlichen Darstellung der Ergänzungsdatensätze bis hin zum ersten Streckendatensatz, wie bei einem Film mit zeitlich aufeinanderfolgenden Einzelbildern (Frames), eine stetige Bewegung wahrgenommen werden würde.

Es ist somit ein maßgeblicher Aspekt der vorliegenden Erfindung, dass für den Fall, dass im ersten (frühesten) Streckendatensatz, also zum Zeitpunkt Null der Aufzeichnungsdauer, die Geschwindigkeit des Sensors von Null verschieden ist, vor den Streckendatensätzen Einleitungsdatensätze eingefügt werden, die in quasistetiger Weise zum ersten Streckendatensatz hinführen. Dies gilt sowohl hinsichtlich einer quasistetigen Relativbewegung aller Objekte relativ zum Sensor als auch hinsichtlich einer Startsituation des Sensors im ersten Ergänzungsdatensatz, die bei einer Geschwindigkeit von Null beginnen soll.

Die Absolutgeschwindigkeit des Sensors ist damit die Geschwindigkeit des Sensors relativ zu Objekten der Umgebung des Sensors, die sich in der Umgebung selbst nicht bewegen. Handelt es sich bei den aufgezeichneten Daten aus der realen Welt um Daten, die mittels eines an einem Kraftfahrzeug angebrachten Sensors beim Befahren einer Straße aufgenommen worden sind, so sind reale Objekte, die sich in der Umgebung nicht bewegen, z. B. die Straße selbst sowie fixe Einrichtungen in der Umgebung, wie Gebäude oder Pflanzen. Objekte, die sich innerhalb der Umgebung bewegen, können z.B. andere Verkehrsteilnehmer sein, wie andere Kraftfahrzeuge oder Fußgänger. Mit dem Begriff "Absolutgeschwindigkeit" ist also die Geschwindigkeit des Sensors bzw. im zuvor beschriebenen Fall die Geschwindigkeit des den Sensor tragenden Kraftfahrzeugs relativ zu fixen Einrichtungen in der Umgebung gemeint.

Im Übrigen sei auch darauf hingewiesen, dass der Begriff "Bild eines realen Objektes" im mathematischen Sinn zu verstehen ist. Es geht also nicht zwingend um eine bildliche Darstellung eines realen Objektes im Sinne einer grafischen Darstellung. Vielmehr sind die Bilder der realen Objekte Daten, nämlich Teil der Streckendaten, und ergeben sich insofern durch eine vom jeweiligen Sensor abhängige mathematische Abbildungsvorschrift aus den von dem Sensor aufgezeichneten Datenwertsätze, die sich aufgrund von von dem Sensor erfassten realen Objekten ergeben haben. Gleichwohl ist es freilich möglich, dass die Bilder der realen Objekte grafisch verkörpert sind.

Der Begriff "Streckendatensätzen, die jeweils eine Szene mit Bildern dieser realen Objekte zu aufeinanderfolgenden Zeitpunkten beschreiben" bedeutet, dass die Streckendatensätze Informationen enthalten, die einerseits die Art oder Eigenschaften der realen Objekte beschreiben, wie z.B. ihre Form, und andererseits auch Informationen, die die Position eines solchen realen Objektes innerhalb der aufgenommenen Szene angeben. Grundsätzlich können diese Informationen in ganz unterschiedlichen Formen vorliegen. Gemäß einer bevorzugten Weiterbildung der Erfindung ist vorgesehen, dass die Streckendatensätzen, die jeweils eine Szene mit Bildern dieser realen Objekte zu aufeinanderfolgenden Zeitpunkten beschreiben, von zeitlich aufeinanderfolgenden Frames gebildet werden, die jeweils eine bildliche Darstellung der Szene enthalten. Die aufeinanderfolgenden Frames (Einzelbilder) bilden damit quasi einen Film dessen, was von dem Sensor bei seiner Bewegung längs der Aufzeichnungsstrecke aufgenommen worden ist. Dabei werden die Bilder der realen Objekte grafisch dargestellt. Dies grafische Darstellung stellt jedoch nur eine Option der Erfindung da, eine bildliche Darstellung von Szenen ist nämlich nicht zwingend erforderlich.

Die Erfindung betrifft ferner die Verwendung von nach einem oben beschriebenen Verfahren gewonnenen Testdaten zum Stimulieren eines zu testenden Steuergeräts. Im Rahmen einer solchen Verwendung ist vorzugsweise vorgesehen, dass das Verfahren die folgenden Schritte aufweist:
Testen eines Steuergeräts mit Testdaten, die gemäß einem der vorhergehenden Ansprüche gewonnenen worden sind, und
wenn das Steuergerät bei der Beaufschlagung mit den Testdaten zeigt, dass es die Testdaten nicht wie in der realen Welt aufgezeichnete Rohdaten akzeptiert, Wiederholen der weiter oben im Detail beschriebenen Verfahrensschritte des Bereitstellens von aufgezeichneten Rohdaten aus der realen Welt, des Ermittelns von von dem Sensor erfassten realen Objekten aus den zeitlich aufeinanderfolgenden Datenwertsätzen und Erstellen von zeitlich aufeinanderfolgenden Streckendatensätzen, die jeweils eine Szene mit Bildern dieser realen Objekte zu aufeinanderfolgenden Zeitpunkten beschreiben, des Bereitstellens einer Bibliothek mit synthetischen Objekten, des Ergänzens der zeitlich aufeinanderfolgenden Streckendatensätze und des Erzeugens der Testdaten zum Stimulieren eines zu testenden Steuergeräts. In diesem Zusammenhang ist es ganz besonders bevorzugt, dass beim Wiederholen dieser Verfahrensschritte Bilder virtueller Objekte den ihnen entsprechenden realen Objekten ähnlicher gestaltet werden. Zusätzlich oder alternativ dazu gilt vorzugsweise, dass beim Wiederholen dieser Verfahrensschritte Bilder solcher virtueller Objekte eingefügt werden, die zuvor, beispielsweise aufgrund einer vermeintlich zu geringen Größe oder einer angenommenen Irrelevanz der ihnen entsprechenden realen Objekte, nicht verwendet worden sind.

Außerdem betrifft die Erfindung ein nichtflüchtiges, computerlesbares Speichermedium mit darauf abgespeicherten Befehlen, die bei ihrer Ausführung auf einem Prozessor ein oben beschriebenes Verfahren bewirken.

Nachfolgend wird die Erfindung anhand eines bevorzugten Ausführungsbeispiels unter Bezugnahme auf die Zeichnungen weiter im Detail erläutert.

In den Zeichnungen zeigen
Fig. 1 schematisch schematisch ein Ablaufdiagramm eines Verfahrens zum Verarbeiten von mittels eines Sensors aufgezeichneten Rohdaten aus der realen Welt zu Testdaten zum Stimulieren eines zu testenden Steuergeräts gemäß einem ersten Ausführungsbeispiel der Erfindung,
Fig. 2 schematisch schematisch ein Ablaufdiagramm eines Verfahrens zum Verarbeiten von mittels eines Sensors aufgezeichneten Rohdaten aus der realen Welt zu Testdaten zum Stimulieren eines zu testenden Steuergeräts gemäß einem zweiten Ausführungsbeispiel der Erfindung,
Fig. 3 eine semantische Beschreibung einer anfänglichen realen Verkehrssituation, die der Zielsituation des Einführungsszenarios entspricht,
Fig. 4 eine semantische Beschreibung des Aufbaus der Straße in dem Einleitungsszenario,
Fig. 5 eine semantische Beschreibung dynamischer Objekte in dem Einleitungsszenario und
Fig. 6 eine semantische Beschreibung des gesamten Einleitungsszenarios.

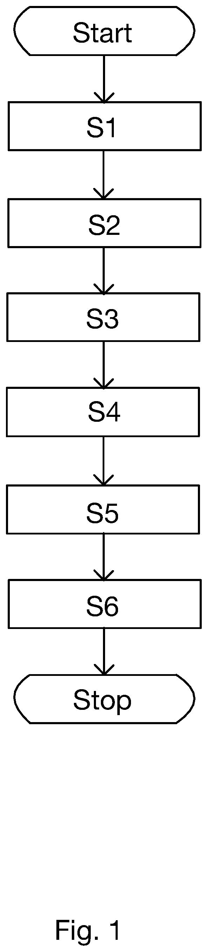

Aus Fig. 1 ist schematisch ein Ablaufdiagramm eines Verfahrens zum Verarbeiten von mittels eines Sensors aufgezeichneten Rohdaten aus der realen Welt zu Testdaten zum Stimulieren eines zu testenden Steuergeräts ersichtlich. Bei diesem Steuergerät kann es sich z.B. um ein Steuergerät handeln, das Aufgaben im Bereich "Advanced Driver Assistance Systems" (ADAS) und "Autonomous Driving" (AD) in einem Kraftfahrzeug übernimmt und dabei z.B. in die Lenkung und in die Geschwindigkeitssteuerung des Kraftfahrzeugs eingreift.

Dieses Verfahren weist die folgenden Verfahrensschritte auf:
In Verfahrensschritt S1 werden vorab aufgezeichnete Rohdaten aus der realen Welt bereitgestellt, die mittels eines Sensors für eine bestimmte Aufzeichnungsdauer längs einer bestimmten Aufzeichnungsstrecke von einem Teil der Umgebung der Aufzeichnungsstrecke aufgezeichnet worden sind. Die Aufzeichnungsstrecke ist also vorab mit einem Kraftfahrzeug abgefahren worden, das einen entsprechenden Sensor aufgewiesen hat, um wenigstens einen Teil der Umgebung der Aufzeichnungsstrecke zu erfassen. Auf diese Weise sind zeitlich aufeinanderfolgende Datenwertsätze erzeugt worden, die sich aufgrund von von dem Sensor erfassten realen Objekten ergeben haben. Freilich ist es im Rahmen der Erfindung möglich und auch bevorzugt, dass das Kraftfahrzeug, mit dem vorab zur Aufzeichnung die Strecke abgefahren worden ist, über mehr als einen Sensor zum Erfassen der Umgebung der Aufzeichnungsstrecke verfügt.

Nachfolgend werden in Verfahrensschritt S2 aus den zeitlich aufeinanderfolgenden Datenwertsätzen von dem Sensor erfasste reale Objekte ermittelt, und es werden zeitlich aufeinanderfolgende Streckendatensätzen erstellt, die jeweils eine Szene mit Bildern dieser realen Objekte zu aufeinanderfolgenden Zeitpunkten beschreiben. Diese Streckendatensätze stellen damit ein Abbild der beim Durchfahren der Aufzeichnungsstrecke erfassten Umgebung dar.

Dann wird in Verfahrensschritt S3 eine Bibliothek mit synthetischen Objekten bereitgestellt. Diese synthetischen Objekte sind vom Prinzip her ebenfalls Bilder realer Objekte, jedoch stellen Sie kein direktes Abbild eines jeweiligen realen Objektes dar. Soll ein synthetisches Objekt z. B. ein anderes Kraftfahrzeug darstellen, so wird die Bibliothek mit synthetischen Objekten nur eine endliche Anzahl von solchen synthetischen Objekten aufweisen, die jeweils ein Kraftfahrzeug darstellen sollen. Typischerweise beschreiben solche synthetischen Objekte jeweils eine Kraftfahrzeugklasse, wie "Kleinwagen", "Kombi", "Limousine", "SUV", "Kleintransporter", "Lastkraftwagen". Die synthetischen Objekte stellen insofern praktisch vereinfachte Bilder der realen Objekte dar. Entsprechendes gilt für synthetische Objekte, die statische Objekte, beispielsweise Gebäude oder Pflanzen, in der Umgebung der Aufzeichnungsstrecke darstellen. Die synthetischen Objekte können insbesondere als 3D-Objekte hinterlegt sein, anhand derer eine Grafik-Engine in einem den aufgezeichneten Rohdaten entsprechenden Datenformat eine zweidimensionale Ansicht eines gegebenen Objekts aus einer beliebigen Perspektive rendern kann.

Nachfolgend wird in Verfahrensschritt S4 die Absolutgeschwindigkeit des Sensors längs der Aufzeichnungsstrecke zum Zeitpunkt Null der Aufzeichnungsdauer ermittelt. Für den Fall, dass die Absolutgeschwindigkeit des Sensors längs der Aufzeichnungsstrecke zum Zeitpunkt Null der Aufzeichnungsdauer von Null verschieden ist, erfolgt ein Ergänzen der zeitlich aufeinanderfolgenden Streckendatensätze für eine Einleitungsdauer vor dem ersten Streckendatensatz mit zeitlich aufeinanderfolgenden Ergänzungsdatensätzen derart, dass der Sensor zum Zeitpunkt Null der Einleitungsdauer eine Absolutgeschwindigkeit von Null aufweist und die zeitlich aufeinanderfolgenden Ergänzungsdatensätze synthetische Objekte aufweisen, die zwischen zeitlich unmittelbar aufeinanderfolgenden Ergänzungsdatensätzen eine quasistetige zeitliche Bewegungsabfolge zeigen, die quasistetig zu den Bildern der realen Objekten des ersten Streckendatensatzes zum Zeitpunkt Null der Aufzeichnungsdauer führt. Dies ist also der Verfahrensschritt im vorliegend beschriebenen Verfahren, in dem ein plausibles Einführungsszenario erstellt wird, um nicht plausible Zustände, die das später zu testende Steuergerät nicht akzeptieren würde, zu vermeiden.

Dann werden in Verfahrensschritt S5 die Testdaten zum Stimulieren eines zu testenden Steuergeräts erzeugt, und zwar durch Konvertieren der Ergänzungsdatensätze zu solchen Rohdaten, wie sie mittels des Sensors während der Einleitungsdauer in der realen Welt aufgezeichnet worden wären, wenn der Sensor die synthetischen Objekte in den zeitlich aufeinanderfolgenden Ergänzungsdatensätzen als reale Objekte erfasst hätte. In Schritt S6 werden dann die aufgezeichneten Rohdaten vor dem ersten Streckendatensatz zum Zeitpunkt Null der Aufzeichnungsdauer mit den durch Konvertieren der Ergänzungsdatensätze erhaltenen Rohdaten ergänzt. Auf diese Weise können beim Testen des Steuergeräts unplausible Zustände vermieden werden, die ansonsten zu einem Abbruch des Tests des Steuergeräts führen würden.

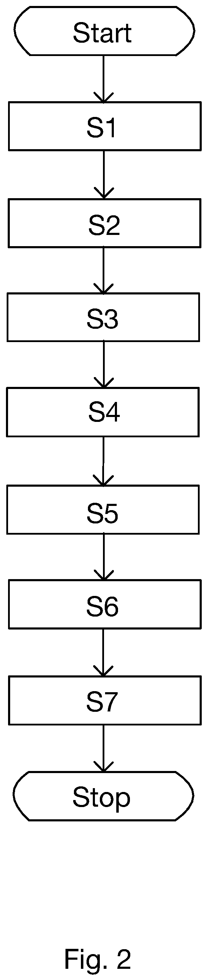

Damit ist das vorliegend in Rede stehende Verfahren zum Verarbeiten der mittels des Sensors aufgezeichneten Rohdaten aus der realen Welt zu Testdaten zum Stimulieren des zu testenden Steuergeräts beendet. Die auf diese Weise erzeugten Testdaten können mehrfach und im Übrigen für unterschiedliche zu testende Steuergeräte verwendet werden. Außerdem können durch das Durchfahren von verschiedenen Aufzeichnungsstrecken unterschiedliche Sätze von Testdaten generiert werden, um derartige Steuergeräte zu testen. Die Erfindung ermöglicht es insofern, unterschiedliche Sätze von Testdaten zu generieren, die in einer eigenen Bibliothek vorgehalten und bedarfsweise zum Testen von Steuergeräten eingesetzt werden können. Gleichwohl ist es freilich möglich, wie schematisch in dem in Fig. 2 dargestellten Ablaufdiagramm gezeigt, nach dem Erstellen der der Testdaten das Testen eines Steuergerätes unmittelbar in einem Verfahrensschritt S7 anzuschließen.

Ein derartiges Verfahren wird nachfolgend anhand der Erstellung eines Einführungsszenarios für eine Radarrohdatenaufnahme beispielhaft erläutert.

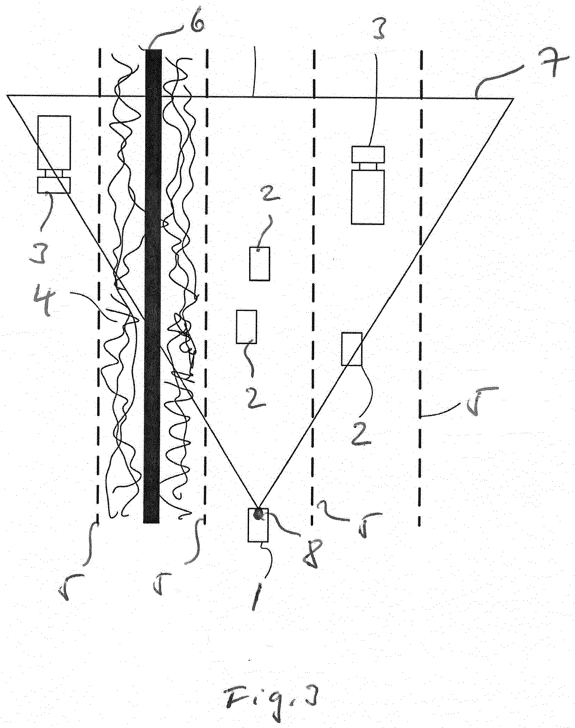

In Fig. 3 ist eine semantische Beschreibung der Verkehrssituation gezeigt, wie sie im ersten Streckendatensatz zum Zeitpunkt Null der Aufzeichnungsdauer der Rohdatenaufnahme vorliegt. Anstatt des Begriffs "Streckendatensatz" wird nachfolgend auch der Begriff "Frame" verwendet. Diese Situation im ersten Streckendatensatz bzw. im ersten Frame ist die Zielsituation, in die das Einführungsszenario möglichst nahtlos hineinführen soll. Zur Rekonstruktion des Verkehrsszenarios können neben dem Radar-Sensor unterstützend andere Sensoren herangezogen werden, wie eine nach vorne gerichtete Kamera, die während der Testfahrt mitläuft. Die semantische Beschreibung der Zielsituation umfasst für jedes erfasste Objekt eine Bezeichnung (Label), eine Position und eine Geschwindigkeit. Das Einführungsszenario umfasst die Position des echten Fahrzeugs 1, mit dem die Streckendatensätze ermittelt worden sind, Bilder anderer Personenkraftwagen 2, Bilder von Lastkraftwagen 3, Bilder von Vegetation 4, Bilder von Fahrspurbegrenzungen 5, falls die Daten nicht ausschließlich von einem Radar-Sensor stammen, und ein Bild einer Leitplanke 6. Zu Illustrationszwecken ist in Fig. 3 auch der Sichtkegel 7 des Radar-Sensors 8 eingezeichnet, der von dem Fahrzeug 1 getragen wird und mit dem die Daten aufgezeichnet worden sind.

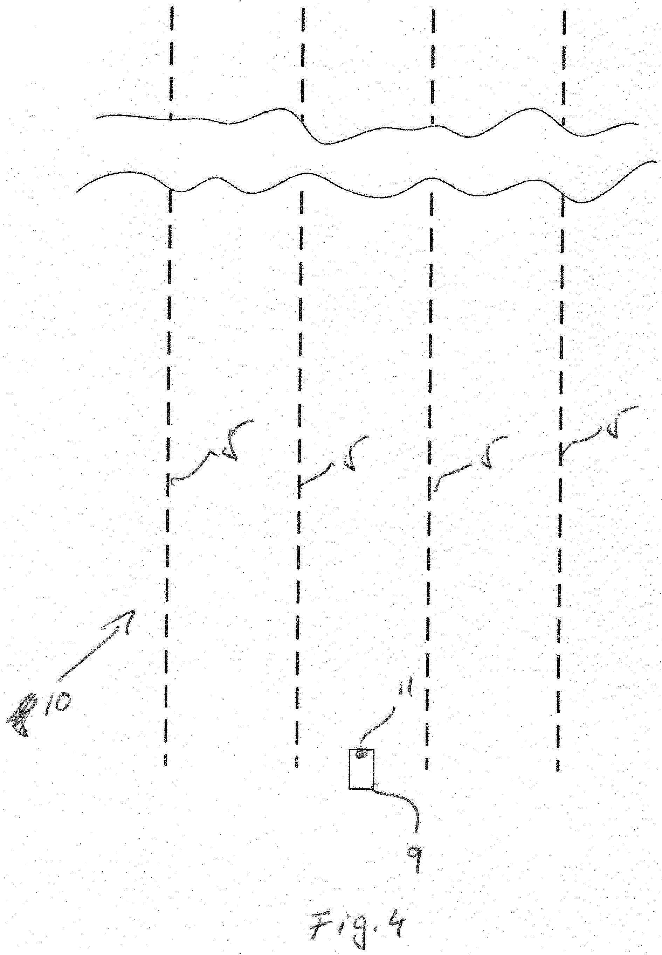

Zum Aufbau des Einführungsszenarios erfolgt in einem ersten Schritt ein virtueller Nachbau eines zur Straße in der Zielsituation passenden Straßenstücks 10, d.h. mit entsprechender Spurenanzahl in passender Breite. Dies ist schematisch aus Fig. 4 ersichtlich. Die Länge des Straßenstücks 10 soll so gewählt werden, dass auf jeden Fall hinreichend Platz für alle synthetischen Objekte bleibt, die zu den Bildern der realen Objekte des ersten Streckendatensatzes zum Zeitpunkt Null der Aufzeichnungsdauer hinführen sollen, insbesondere zu solchen, die dynamische Objekte darstellen und sich absolut im Raum des Szenarios bewegen. Ein virtuelles Testfahrzeug 9, auch Ego-Fahrzeug genannt, wird an der Querposition, die der Position des echten Testfahrzeugs 1 im Zielszenario entspricht, auf der Straße positioniert und dann von Null auf die Zielgeschwindigkeit, d.h. die Geschwindigkeit des Testfahrzeugs im Zielszenario (im ersten Streckendatensatz) beschleunigt. Das virtuelle Testfahrzeug 9 ist mit einem virtuellen Radar-Sensor 11 an genau der Stelle ausgestattet, an der der echte Radar-Sensor 8 im Testfahrzeug angebracht gewesen ist.

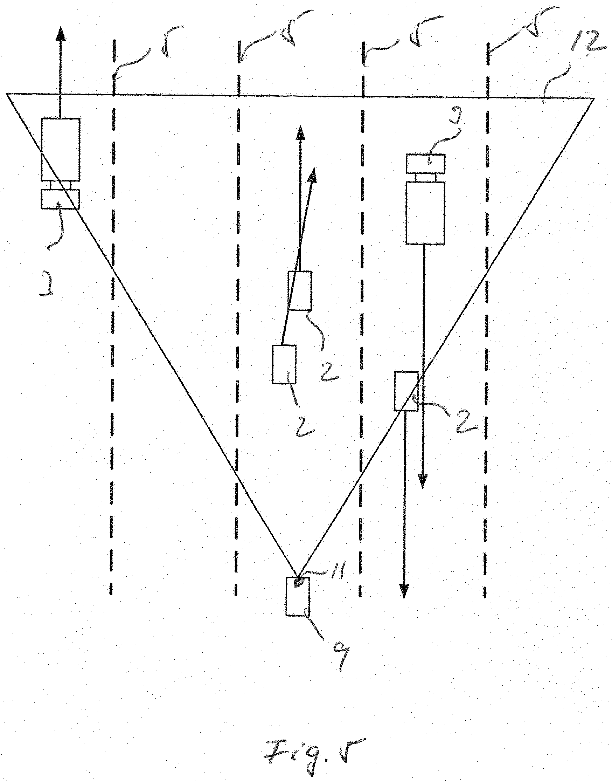

Wenn das virtuelle Testfahrzeug 9 auf die Zielgeschwindigkeit eingeregelt ist, wird, wie schematisch in Fig. 5 dargestellt, für jedes dynamische Objekt aus der Zielsituation ein passendes virtuelles Objekt, das ein ähnliches Radarbild erzeugt, an derselben relativen Position positioniert. Danach wird jedes dynamische Objekt an eine Ausgangsposition durch Rückwärts-Extrapolation, in der Abbildung dargestellt durch Pfeile, des jeweiligen dynamischen Objekts auf Basis seiner Absolutgeschwindigkeit im Zielszenario verschoben. Dabei wird so weit extrapoliert, dass sich alle Ausgangspositionen außerhalb des Sichtkegels 12 des virtuellen Radar-Sensors 11 befinden.

Falls die relative Geschwindigkeit eines dynamischen Objekts gleich Null oder annähernd gleich Null ist, positioniert man dieses Objekt knapp außerhalb des Sichtkegels 12 des virtuellen Radar-Sensors 11 und gibt einem Regler, der das Objekt ansteuert, die relative Zielposition des Objekts als Sollwert vor.

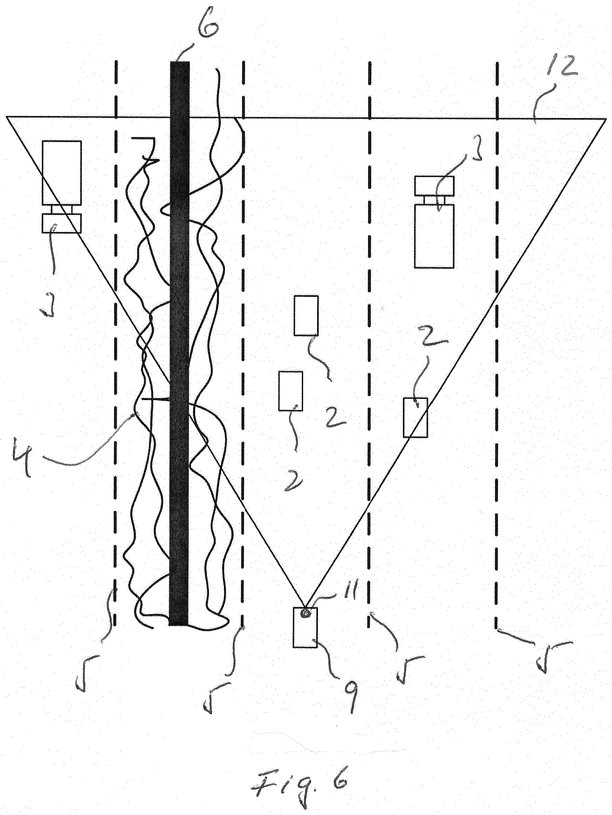

Nun werden die Szenen aus Fig. 4 und Fig. 5 zu einem Szenario zusammengefügt, wie in Fig. 6 dargestellt, bis sich alle dynamischen Objekte an der korrekten Zielposition befinden. Außerdem ist aus Fig. 6 ersichtlich, dass von der Position an, an der das virtuelle Testfahrzeug 9 platziert worden ist, nun das Einleitungsszenario mit statischen Objekten aus dem Zielszenario aufgefüllt wird, so dass in den letzten Frames des Einleitungsszenarios zumindest die wichtigsten statischen Objekte bereits sichtbar sind, die auch im ersten Frame, also im ersten Streckendatensatz, der dem Zielszenario entspricht, sichtbar sind und keine statischen Objekte aus dem Nichts auftauchen. Beispielhaft ist dargestellt, wie in der nahen Umgebung der Zielposition des virtuellen Testfahrzeugs 9, die es im letzten Frame des Einleitungsszenarios einnimmt, das Einführungsszenario mit synthetischen Gegenstücken der Leitplanke 6 und der Vegetation 4 aufgefüllt wird.

Dann wird das Einführungsszenario simuliert, diese Simulation wird in eine synthetische Radarrohdatenaufnahme konvertiert und dann der echten Aufnahme voran angefügt, so dass beide nahtlos ineinander übergehen. Daran schließt sich eine Testphase an, in der geprüft wird, ob ein zu testendes Steuergerät das Einleitungsszenario akzeptiert, d.h. ob der Übergang vom Einleitungsszenario in die echte Aufnahme ohne Fehlermeldung oder ungewöhnliches Verhalten des Steuergeräts vonstattengeht.

Falls das der Fall ist, ist das Verfahren abgeschlossen. Falls nicht, wird nachgebessert. Zum Beispiel werden virtuelle Objekte, und zwar statische und/oder dynamische Objekte, ihren realen Gegenstücken aus der Aufnahme ähnlicher gestaltet und/oder es werden weitere statische Objekte eingefügt, die vorher wegen ihres kleinen Radarquerschnitts ignoriert wurden. Hier gilt der Grundsatz: Es wird größere Sorgfalt bei den Objekten angewandt, die aus Sicht des jeweiligen Steuergeräts interessant sind. Beispielsweise wird ein Algorithmus eines Spurhalteassistenten besonders auf Begrenzungen der Fahrspur achten, wie auf Seitenlinien, Leitplanken, Bordsteine usw., und andere Objekte wie Fahrzeuge, Fußgänger und Vegetation eher ignorieren. Es wird solange nachgebessert, bis das jeweilige Steuergerät das Einführungsszenario akzeptiert.

### Bezugszeichenliste

| | |
|---|---|
| Position des echten Fahrzeugs | 1 |
| Bilder anderer Personenkraftwagen | 2 |
| Bilder von Lastkraftwagen | 3 |
| Bilder von Vegetation | 4 |
| Bilder von Fahrspurbegrenzungen | 5 |
| Bild einer Leitplanke | 6 |
| Radar-Sensor | 7 |
| Sichtkegel des Radar-Sensors | 8 |
| virtuelles Testfahrzeug | 9 |
| Straßenstück | 10 |
| virtueller Radar-Sensor | 11 |
| Sichtkegel virtuellen Radar-Sensors | 12 |

## Patentansprüche

1. Computerimplementiertes Verfahren zum Verarbeiten von mittels eines Sensors aufgezeichneten Rohdaten aus der realen Welt zu Testdaten zum Stimulieren eines zu testenden Steuergeräts, mit folgenden Verfahrensschritten:
Bereitstellen von aufgezeichneten Rohdaten aus der realen Welt, die mittels eines Sensors für eine Aufzeichnungsdauer längs einer Aufzeichnungsstrecke von wenigstens einem Teil der Umgebung der Aufzeichnungsstrecke aufgezeichnet worden sind und dabei zeitlich aufeinanderfolgende Datenwertsätze aufweisen, die sich aufgrund von von dem Sensor erfassten realen Objekten ergeben haben,
Ermitteln von von dem Sensor erfassten realen Objekten aus den zeitlich aufeinanderfolgenden Datenwertsätzen und Erstellen von zeitlich aufeinanderfolgenden Streckendatensätzen, die jeweils eine Szene mit Bildern dieser realen Objekte zu aufeinanderfolgenden Zeitpunkten beschreiben,
Bereitstellen einer Bibliothek mit synthetischen Objekten,
Ermitteln der Absolutgeschwindigkeit des Sensors längs der Aufzeichnungsstrecke zum Zeitpunkt Null der Aufzeichnungsdauer und für den Fall, dass die Absolutgeschwindigkeit des Sensors längs der Aufzeichnungsstrecke zum Zeitpunkt Null der Aufzeichnungsdauer von Null verschieden ist, Ergänzen der zeitlich aufeinanderfolgenden Streckendatensätze für eine Einleitungsdauer vor dem ersten Streckendatensatz mit zeitlich aufeinanderfolgenden Ergänzungsdatensätzen derart, dass der Sensor zum Zeitpunkt Null der Einleitungsdauer eine Absolutgeschwindigkeit von Null aufweist und die zeitlich aufeinanderfolgenden Ergänzungsdatensätze synthetische Objekte aufweisen, die zwischen zeitlich unmittelbar aufeinanderfolgenden Ergänzungsdatensätzen eine quasistetige zeitliche Bewegungsabfolge zeigen, die quasistetig zu den Bildern der realen Objekte des ersten Streckendatensatzes zum Zeitpunkt Null der Aufzeichnungsdauer führen, und
Erzeugen der Testdaten zum Stimulieren eines zu testenden Steuergeräts durch Konvertieren der Ergänzungsdatensätze zu solchen Rohdaten, wie sie mittels des Sensors während der Einleitungsdauer in der realen Welt aufgezeichnet worden wären, wenn der Sensor die synthetischen Objekte in den zeitlich aufeinanderfolgenden Ergänzungsdatensätzen als reale Objekte erfasst hätte, und Ergänzen der aufgezeichneten Rohdaten vor dem ersten Streckendatensatz zum Zeitpunkt Null der Aufzeichnungsdauer mit den durch Konvertieren der Ergänzungsdatensätze erhaltenen Rohdaten.

2. Verfahren nach Anspruch 1, wobei die Streckendatensätzen, die jeweils eine Szene mit Bildern dieser realen Objekte zu aufeinanderfolgenden Zeitpunkten beschreiben, von zeitlich aufeinanderfolgenden Frames gebildet werden, die jeweils eine bildliche Darstellung der Szene enthalten.

3. Verfahren nach Anspruch 1 oder 2, wobei die synthetische Objekte, die zwischen zeitlich unmittelbar aufeinanderfolgenden Ergänzungsdatensätzen eine quasistetige zeitliche Bewegungsabfolge zeigen, die quasistetig zu den Bildern der realen Objekte des ersten Streckendatensatzes zum Zeitpunkt Null der Aufzeichnungsdauer führen, derart gewählt werden, dass sie im Rahmen einer Beurteilung mittels einer vorbestimmten Metrik oder im Rahmen einer Beurteilung durch ein entsprechend trainiertes künstliches neuronales Netzwerk als in einem vorbestimmten Ähnlichkeitsbereich zu den Bildern der realen Objekte, zu denen sie hinführen, angesehen werden.

4. Verfahren nach Anspruch 3, wobei ein synthetisches Objekt als im vorbestimmten Ähnlichkeitsbereich zu dem Bild eines realen Objekts liegend angesehen wird, wenn die Rohdaten, die mittels des Sensors von einem realen Objekt aufgezeichnet worden wären, das dem synthetischen Objekt entspricht, in einem vorbestimmten Ähnlichkeitsbereich zu den Rohdaten liegen, die von dem Sensor von dem realen Objekt aufgezeichnet worden sind, zu dessen Bild das synthetische Objekt führt.

5. Verfahren nach einem der vorhergehenden Ansprüche, wobei der Sensor einen Radar-Sensor, einen Lidar-Sensor, eine Kamera und/oder einen Ultraschallsensor beinhaltet.

6. Verfahren nach einem der vorhergehenden Ansprüche, mit folgenden Schritten:
Testen eines Steuergeräts mit Testdaten, die gemäß einem der vorhergehenden Ansprüche gewonnenen worden sind, und
Wiederholen der Verfahrensschritte aus Anspruch 1, wenn das Steuergerät bei der Beaufschlagung mit den Testdaten zeigt, dass es die Testdaten nicht wie in der realen Welt aufgezeichnete Rohdaten akzeptiert.

7. Verfahren nach Anspruch 6, wobei beim Wiederholen der Verfahrensschritte aus Anspruch 1 Bilder virtueller Objekte den ihnen entsprechenden realen Objekten ähnlicher gestaltet werden.

8. Verfahren nach Anspruch 6 oder 7, wobei beim Wiederholen der Verfahrensschritte aus Anspruch 1 Bilder solcher virtueller Objekte eingefügt werden, die zuvor aufgrund einer zu geringen Größe der ihnen entsprechenden realen Objekte nicht verwendet worden sind.

9. Verwendung von nach einem Verfahren gemäß einem der vorhergehenden Ansprüche gewonnenen Testdaten zum Stimulieren eines zu testenden Steuergeräts.

10. Nichtflüchtiges, computerlesbares Speichermedium mit darauf abgespeicherten Befehlen, die bei ihrer Ausführung auf einem Prozessor ein Verfahren nach einem der Ansprüche 1 bis 8 bewirken.

11. Nichtflüchtiges, computerlesbares Speichermedium mit darauf abgespeicherten Testdaten, die gemäß einem der Ansprüche 1 bis 8 gewonnenen worden sind.

## Claims

1. A computer-implemented method for processing raw data recorded by a sensor from the real world into test data for stimulating a control unit to be tested, comprising the following method steps:
providing recorded raw data from the real world recorded by means of a sensor for a recording period along a recording path of at least a part of the environment of the recording path, said data comprising temporally consecutive data value sets having resulted from real objects detected by the sensor,
determining real objects detected by the sensor from the consecutive data value sets and creating consecutive path data sets, each of which describes a scene having images of said real objects at consecutive points in time,
providing a library having synthetic objects,
determining the absolute velocity of the sensor along the recording path at time zero of the recording period and, in the event that the absolute velocity of the sensor along the recording path at time zero of the recording period is different from zero, supplementing the temporally consecutive path data set for an initiation period before the first path data set having temporally consecutive supplemental data sets, such that the sensor has an absolute velocity of zero at time zero of the initiation period and the temporally consecutive supplementary data sets have synthetic objects showing a quasi-synchronous temporal sequence of movements between temporally immediately consecutive supplementary data sets quasi-synchronously leading to the images of the real objects of the first path data set at time zero of the recording period, and
generating the test data for stimulating a control unit to be tested by converting the supplemental data sets to such raw data as would have been recorded by the sensor during the initiation period in the real world if the sensor had detected the synthetic objects in the successive supplemental data sets as real objects, and supplementing the recorded raw data before the first path data set at time zero of the recording period with the raw data obtained by converting the supplemental data sets.

2. The method according to claim 1, wherein the path data sets, each describing a scene having images of said real objects at successive points in time, are formed by successive frames, each containing a pictorial representation of the scene.

3. The method according to claim 1 or 2, wherein the synthetic objects showing a quasi-synchronous temporal sequence of movements between immediately successive supplementary data sets leading quasi-synchronously to the images of the real objects of the first path data set at time zero of the recording period, are selected in such a way that said objects are considered to be within a predetermined similarity range to the images of the real objects to which said objects lead in the context of an assessment by means of a predetermined metric or in the context of an assessment by a correspondingly trained artificial neural network.

4. The method according to claim 3, wherein a synthetic object is considered to be in the predetermined similarity range to the image of a real object when the raw data that would have been recorded by the sensor from a real object corresponding to the synthetic object is in a predetermined similarity range to the raw data recorded by the sensor from the real object to whose image the synthetic object leads.

5. The method according to any one of the preceding claims, wherein the sensor comprises a radar sensor, a lidar sensor, a camera, and/or an ultrasonic sensor.

6. The method according to any one of the preceding claims, having the following steps:
testing a control unit by means of test data obtained according to any one of the preceding claims, and
repeating the method steps of claim 1 if the control unit, when exposed to the test data, shows that said device does not accept the test data as raw data recorded in the real world.

7. The method according to claim 6, wherein, when repeating the method steps of claim 1, images of virtual objects are made more similar to the real objects corresponding thereto.

8. The method according to claim 6 or 7, wherein when repeating the method steps of claim 1, images of such virtual objects are inserted that have not been used before due to an insufficient size of the real objects corresponding thereto.

9. A use of test data obtained by a method according to any one of the preceding claims for stimulating a control unit to be tested.

10. A non-volatile, computer-readable storage medium having instructions stored thereon which, when executed on a processor, cause a method according to any one of claims 1 to 8 to be carried out.

11. A non-volatile, computer-readable storage medium having test data stored thereon which has been obtained according to any one of claims 1 to 8.

## Revendications

1. Procédé mis en œuvre par ordinateur pour le traitement de données brutes du monde réel, enregistrées au moyen d'un capteur, en données de test afin de stimuler un appareil de commande à tester, comprenant les étapes de procédé suivantes:
mettre à disposition des données brutes enregistrées du monde réel, qui ont été enregistrées au moyen d'un capteur pendant une durée d'enregistrement le long d'un trajet d'enregistrement d'au moins une partie de l'environnement du trajet d'enregistrement et qui présentent à cet égard des ensembles de valeurs de données successifs dans le temps, qui ont résulté en raison d'objets réels détectés par le capteur,
déterminer des objets réels détectés par le capteur à partir des ensembles de valeurs de données successifs dans le temps et création d'ensembles de données de trajets successifs dans le temps, qui décrivent chacun une scène avec des images de ces objets réels à des instants successifs,
mettre à disposition une bibliothèque d'objets synthétiques,
déterminer la vitesse absolue du capteur le long du trajet d'enregistrement à l'instant zéro de la durée d'enregistrement et, dans le cas où la vitesse absolue du capteur le long du trajet d'enregistrement est différente de zéro à l'instant zéro de la durée d'enregistrement, compléter les ensembles de données de trajets successifs dans le temps pour une durée d'initiation avant le premier ensemble de données de trajet par des ensembles de données de complément successifs dans le temps de telle sorte que le capteur présente une vitesse absolue de zéro à l'instant zéro de la durée d'initiation et que les ensembles de données de complément successifs dans le temps présentent des objets synthétiques qui, entre des ensembles de données de complément immédiatement successifs dans le temps, montrent une séquence temporelle de mouvements quasi-continue, qui conduisent quasi-continuellement aux images des objets réels du premier ensemble de données de trajet à l'instant zéro de la durée d'enregistrement, et
générer les données de test afin de stimuler un appareil de commande à tester en convertissant les ensembles de données de complément en données brutes telles qu'elles auraient été enregistrées au moyen du capteur pendant la durée d'initiation dans le monde réel si le capteur avait détecté les objets synthétiques en tant qu'objets réels dans les ensembles de données de complément successifs dans le temps, et compléter les données brutes enregistrées avant le premier ensemble de données de trajet à l'instant zéro de la durée d'enregistrement par les données brutes obtenues par conversion des ensembles de données de complément.

2. Procédé selon la revendication 1, les ensembles de données de trajet, qui décrivent chacun une scène avec des images de ces objets réels à des instants successifs, étant formés par des trames successives dans le temps, qui contiennent chacune une représentation en image de la scène.

3. Procédé selon la revendication 1 ou 2, les objets synthétiques qui, entre des ensembles de données de complément immédiatement successifs dans le temps, montrent une séquence temporelle de mouvements quasi-continue, qui conduisent quasi-continuellement aux images des objets réels du premier ensemble de données de trajet à l'instant zéro de la durée d'enregistrement, étant choisis de telle sorte que, dans le cadre d'une évaluation au moyen d'une métrique prédéterminée ou dans le cadre d'une évaluation par un réseau neuronal artificiel entraîné en conséquence, ils sont considérés comme se situant dans une plage prédéterminée de similarité avec les images des objets réels auxquels ils mènent.

4. Procédé selon la revendication 3, un objet synthétique étant considéré comme se situant dans la plage prédéterminée de similarité avec l'image d'un objet réel si les données brutes qui auraient été enregistrées au moyen du capteur pour un objet réel qui correspond à l'objet synthétique se situent dans une plage prédéterminée de similarité avec les données brutes qui ont été enregistrées par le capteur pour l'objet réel à l'image duquel l'objet synthétique conduit.

5. Procédé selon l'une des revendications précédentes, le capteur comprenant un capteur radar, un capteur lidar, une caméra et/ou un capteur à ultrasons.

6. Procédé selon l'une des revendications précédentes, comprenant les étapes suivantes :
tester un appareil de commande avec des données de test qui ont été obtenues selon l'une des revendications précédentes, et
répéter les étapes du procédé de la revendication 1 si l'appareil de commande, lorsque lui sont appliquées les données de test, indique qu'il n'accepte pas les données de test comme des données brutes enregistrées dans le monde réel.

7. Procédé selon la revendication 6, lors de la répétition des étapes de procédé de la revendication 1, des images d'objets virtuels étant rendues plus semblables aux objets réels qui leur correspondent.

8. Procédé selon la revendication 6 ou 7, lors de la répétition des étapes de procédé de la revendication 1, des images de tels objets virtuels étant insérées, qui n'ont pas été utilisés auparavant en raison d'une taille trop petite des objets réels qui leur correspondent.

9. Utilisation de données de test obtenues par un procédé selon l'une des revendications précédentes pour stimuler un appareil de commande à tester.

10. Support de stockage non volatile lisible par ordinateur, sur lequel sont mémorisées des instructions qui, lorsqu'elles sont exécutées sur un processeur, mettent en œuvre un procédé selon l'une des revendications 1 à 8.

11. Support de stockage non volatile lisible par ordinateur, sur lequel sont mémorisées des données de test qui ont été obtenues selon l'une des revendications 1 à 8.
